# EUROPEAN PATENT SPECIFICATION

(11) **EP 3 843 122 B1**
(45) Date of publication and mention of the grant of the patent: **14.12.2022**
(21) Application number: 21150886.6
(22) Date of filing: 11.01.2021
(51) Int. Cl.: H01J 37/32, H01L 21/677

(54) **PLASMA TREATMENT APPARATUS**
PLASMABEHANDLUNGSVORRICHTUNG
APPAREIL DE TRAITEMENT AU PLASMA

(30) Priority: 25.12.2019 JP 2019234389
(43) Date of publication of application: 30.06.2021
(73) Proprietor: Plasma Ion Assist Co., Ltd., Kyoto-shi, Kyoto 612-8373 (JP)
(72) Inventor: SUZUKI, Yasuo, Shiga 520-0225 (JP); SUZUKI, Hirokazu, Kyoto 617-0002 (JP)
(74) Representative: Müller Hoffmann & Partner

(56) References cited:
- JP-A- 2019 117 773
- US-A- 4 894 133
- US-A- 5 215 420
- US-A1- 2018 053 639

## Description

### BACKGROUND

### Technical Field

The present disclosure relates to a plasma treatment apparatus, such as, for example, an apparatus for manufacturing a separator for a fuel cell.

### Description of Related Art

As this type of plasma treatment apparatus, Patent literature 1 discloses a so-called roll-to-roll type in which a base material wound on a delivery roll is delivered, a film is formed thereon by a plasma treatment, and the base material on which the film is formed is wound up by a winding roll.

Since such a roll-to-roll type plasma treatment apparatus can perform a continuous film forming treatment, it has advantages such as a high treatment speed and a high manufacturing efficiency.

However, when a film is formed on a base material which is difficult to wind on a roll, for example, such as a base material having irregularities or a thick base material, there is a problem that it is difficult to apply the above-described roll-to-roll type apparatus.

US 4 894 133 A describes a sputtering production assembly for producing a magnetic thin-film memory disk and method of coating the memory disk. The magnetic disk substrates are preliminarily abraded to provide a uniform series of physical circumferential texturing to encourage a circular anisotropic orientation of crystal growth during the subsequent sputtering steps. A nucleating layer is deposited under controlled conditions, and subsequently a thin-film magnetic layer is deposit with circular anisotropic orientation of crystal growth. Finally, a thin-film protective coating is disposed on the magnetic layer.

US 5 215 420 A describes a system for handling and processing thin substrates, such as substrates for magnetic disks. The system includes a main chamber, entrance and output load locks, a buffer chamber, substrate load/unload mechanism, and a plurality of substrate processing stations positioned contiguous with the main vacuum chamber.

US 2018/0053639 A1 describes an apparatus for treating the surface of objects with plasma, having: an enclosure; a means for placing this enclosure under vacuum; a zone for storing objects to be treated, which is called the upstream storing zone; a zone for storing treated objects, which is called the downstream storing zone; at least two plasma treatment chambers having a means for injecting an active gas mixture, a means for creating an electrical discharge and a means for confining the plasma to the volume inside the chamber; and a means for transferring between the storing zones and the chambers, characterized in that the transferring means are conveying means defining a conveying direction, and in that the various chambers are placed one behind the other, in the conveying direction, and in that the atmospheres of the various plasma treatment chambers are not hermetically sealed off from one another.

JP 2019117773 A describes a method of manufacturing a fuel cell separator comprising: a gas barrier film forming process for forming a gas barrier film on at least one surface of a substrate, and a groove forming process for forming a groove on the substrate after the gas barrier film forming process.

### [Literature of related art]

### [Patent literature]

[Patent literature 1] Japanese Patent Laid-Open No. 2019-117773

### SUMMARY

### [Problems to be Solved]

The invention is defined by the appended claims. References to embodiments which do not fall under the scope of the claims are to be understood as examples useful for the invention.

Therefore, the present disclosure has been made to solve the above-described problems, and is for enabling a continuous plasma treatment even for a base material which is difficult to wind on a roll.

### [Means to Solve Problems]

That is, a plasma treatment apparatus according to the present disclosure includes a plurality of plasma treatment chambers in which a plasma treatment is performed on a base material, a tray configured to hold the base material in a standing posture, and a lift mechanism configured to continuously convey the tray to the plurality of plasma treatment chambers.

According to the plasma treatment apparatus having such a configuration, since the tray holding the base material is continuously conveyed to the plurality of plasma treatment chambers by the lift mechanism, a film formation treatment can be performed continuously even when the base material is difficult to wind on a roll.

The plurality of plasma treatment chambers may communicate with each other, and a differential exhaust chamber may be provided between the chambers.

With such a configuration, the trays can be continuously conveyed, and each of the plasma treatment chambers can be maintained at a desired degree of vacuum by communicating the plurality of plasma treatment chambers with each other.

To make the lift mechanism a simple configuration, the lift mechanism comprises a rope which spans the plurality of plasma treatment chambers and on which the tray is hooked, and a drive source which moves the rope between the plurality of plasma treatment chambers.

A plurality of the trays may be installed, and a conveyance mechanism which sequentially conveys the trays to the rope may be further included.

With such a configuration, a plurality of trays can be automatically delivered in sequence, a film can be continuously formed on a large number of base materials held in the plurality of trays at once, and higher efficiency can be achieved.

As an aspect for realizing such automatic delivery of the trays, the conveyance mechanism may have an endless belt that feeds the tray to the rope, and a hooking part provided on the tray may be hooked on the rope and the tray may be suspended from the rope as the tray falls from an edge of the endless belt.

A plasma cleaning chamber in which the base material is plasma-cleaned, an ion implantation chamber in which carbon ions are implanted into the base material, a first film formation chamber in which a DLC film is formed on one surface of the base material, a second film formation chamber in which a DLC film is formed on the other surface of the base material, and a hydrophilic treatment chamber in which the base material is hydrophilically treated with oxygen plasma may be provided as the plasma treatment chamber, and the lift mechanism may convey the tray to the plasma cleaning chamber, the ion implantation chamber, the first film formation chamber, the second film formation chamber, and the hydrophilic treatment chamber in that order.

With such a configuration, since the tray holding the base material in the standing posture is conveyed to the plasma cleaning chamber, the ion implantation chamber, the first film formation chamber, the second film formation chamber, and the hydrophilic treatment chamber, the plasma treatment can be performed on both surfaces of the base material in each of the chambers, and a DLC film can be efficiently formed on the base material.

As a more specific aspect for plasma-treating both surfaces of the base material, in each of the plasma cleaning chamber, the ion implantation chamber, and the hydrophilic treatment chamber, at least a pair of antennas which generates plasma in the chamber may be provided at positions at which the base material is sandwiched therebetween.

### [Effect]

According to the present disclosure having such a configuration, it is possible to enable a continuous plasma treatment even for a base material which is difficult to wind on a roll.

### BRIEF DESCRIPTION OF THE DRAWINGS

FIG. 1 is a schematic view showing a configuration of a plasma treatment apparatus according to the present embodiment.
FIG. 2 is a schematic view showing the configuration of the plasma treatment apparatus according to the present embodiment.
FIG. 3 is a schematic view showing a configuration of a tray according to the present embodiment.
FIG. 4 is a schematic view showing a configuration of a conveyance mechanism according to the present embodiment.
FIG. 5 is a schematic view showing a configuration of a plasma treatment apparatus according to another embodiment.
FIG. 6 is a schematic view showing a configuration of a plasma treatment apparatus according to another embodiment.

### DESCRIPTION OF THE EMBODIMENTS

An embodiment of a plasma treatment apparatus according to the present disclosure will be described below with reference to the drawings.

The plasma treatment apparatus of the present embodiment is a continuous film forming apparatus capable of continuously forming a film on a plurality of sheets of base materials. Hereinafter, a case in which a gas barrier film used for manufacturing a separator for a fuel cell or the like and having corrosion resistance to an acid or an alkali is formed on a base material will be described as an example. The base material is, for example, an aluminum substrate or the like, and the gas barrier film is, for example, a DLC film which has conductivity and curbs penetration of sulfuric acid water which causes corrosion. However, the base material and the film formed on the base material are not limited to the following embodiments, and may be appropriately changed.

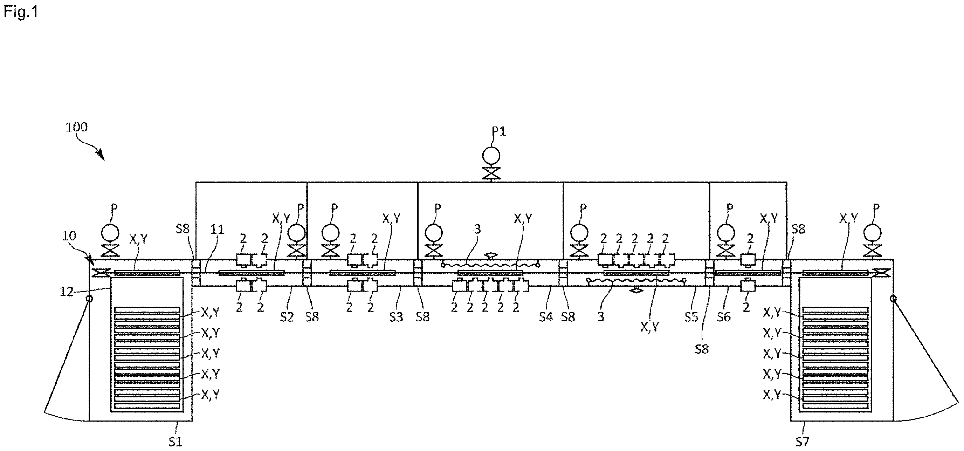

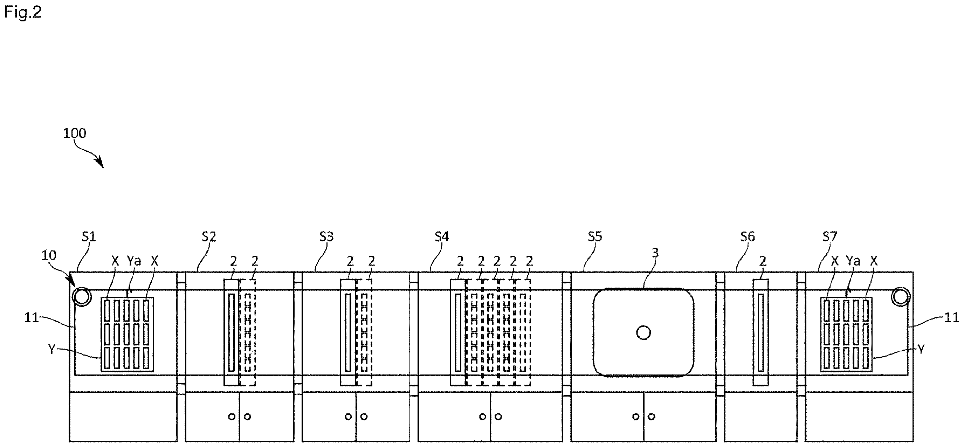

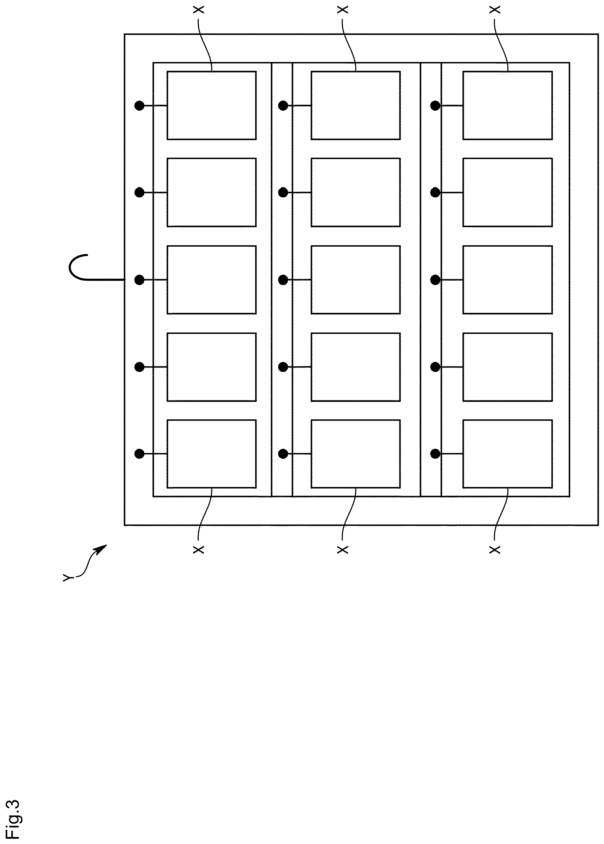

As shown in FIGS. 1 and 2, a plasma treatment apparatus 100 is configured to convey a base material X to a plurality of plasma treatment chambers S2 to S6 along with a tray Y while the base material X is held in the tray Y in a standing posture. The standing posture referred to here is preferably a posture in a vertical direction, but the posture is not necessarily limited to this posture, and a posture tilted from the vertical direction may be used. Further, as shown in FIG. 3, the tray Y has a frame shape, and a plurality of sheets of base materials X is suspended and held vertically and horizontally in the frame.

Specifically, as shown in FIGS. 1 and 2, the plasma treatment apparatus 100 includes a tray delivery chamber S1, a plasma cleaning chamber S2, an ion implantation chamber S3, a first film formation chamber S4, a second film formation chamber S5, a hydrophilic treatment chamber S6, a tray storage chamber S7, and a lift mechanism 10 which conveys the base material X along with the tray Y to each of the chambers.

The tray delivery chamber S1 is a chamber for accommodating a plurality of trays Y and sequentially delivering the trays Y to each of treatment chambers which will be described later. Air in the tray delivery chamber S1 is exhausted by a suction mechanism P such as a vacuum pump, and thus the tray delivery chamber S1 is maintained at a predetermined degree of vacuum.

The plasma cleaning chamber S2 is a treatment chamber in which the base material X held in the tray Y is loaded along with the tray Y delivered from the tray delivery chamber S1 and is plasma-cleaned. Specifically, in the plasma cleaning chamber S2, at least a pair of antennas 2 is provided at positions at which the base material X is sandwiched therebetween, and in this embodiment, two sets of the inductively coupled antennas 2 are arranged and provided in a conveying direction. Then, inductively coupled discharge plasma containing argon ions is generated in the vicinity of a front surface and a back surface of the base material X by applying high-frequency power from a high-frequency power source (not shown) to the antennas 2 via a matching device (not shown) and supplying argon gas into the chamber as a cleaning gas. One surface (hereinafter, also referred to as a front surface) and the other surface (hereinafter, also referred to as a back surface) of the base material X are cleaned by this argon plasma.

The ion implantation chamber S3 is a treatment chamber in which the base material X held in the tray Y is loaded along with the tray Y delivered from the plasma cleaning chamber S2, and carbon ions are implanted into the base material X. This ion implantation is a treatment for forming nuclei (like hair roots in hair) on the base material X in order to improve adhesion of the DLC film which will be described later. Specifically, in the ion implantation chamber S3, at least a pair of antennas 2 are provided at positions at which the base material X is sandwiched therebetween, and in this embodiment, two sets of the pair of inductively coupled antennas 2 are arranged and provided in the conveying direction. The discharge plasma of the inductively coupled antenna 2 containing carbon ions is generated in the vicinity of the front surface and the back surface of the base material X by applying high-frequency power from the high-frequency power source (not shown) to the antennas 2 via the matching device (not shown) and supplying a carbon compound gas such as methane into the chamber as a raw material gas. Additionally, carbon ions are implanted into the front surface and the back surface of the base material X and thus nuclei which contribute to improving the adhesion of the DLC film are formed by applying a negative DC voltage or a negative pulse voltage from a bias power source (not shown) to the base material X.

The first film formation chamber S4 is a treatment chamber in which the base material X held in the tray Y is loaded along with the tray Y delivered from the ion implantation chamber S3, and a DLC film is formed on one surface (the front surface) of the base material X. Specifically, in the first film formation chamber S4, one or a plurality of antennas 2 is provided on the front surface side of the base material X, and in this embodiment, five inductively coupled antennas 2 are arranged and provided in the conveying direction. On the other hand, a heater 3 is provided on the back surface side of the base material X.

Then, inductively coupled discharge plasma containing carbon ions is generated in the vicinity of the front surface of the base material X by applying high-frequency power from the high-frequency power source (not shown) to the above-described antennas 2 via the matching device (not shown) and supplying a mixed gas of, for example, nitrogen, methane, and acetylene as a raw material gas into the chamber. At this time, in order to make the DLC film conductive, the base material X is basically heated to, for example, 150 to 400 °C by the above-described heater 3. Then, a conductive DLC film is formed on the front surface of the base material X by applying a negative DC voltage or a negative pulse voltage from the bias power source (not shown) to the base material X and additionally heating the base material X with the heater 3 or ion energy in the plasma.

The second film formation chamber S5 is a treatment chamber in which the base material X held in the tray Y is loaded along with the tray Y delivered from the first film formation chamber S4, and the DLC film is formed on the other surface (the back surface) of the base material X. Specifically, in the second film formation chamber S5, one or a plurality of antennas 2 is provided on the back surface side of the base material X, and in this embodiment, five inductively coupled antennas 2 are arranged and provided in the conveying direction. On the other hand, the heater 3 is provided on the front surface side of the base material X.

Then, inductively coupled discharge plasma containing carbon ions is generated in the vicinity of the back surface of the base material X by applying high-frequency power from the high-frequency power source (not shown) to the above-described antennas 2 via the matching device (not shown) and supplying a mixed gas of, for example, nitrogen, methane, and acetylene as a raw material gas into the chamber. At this time, in order to make the DLC film conductive, the base material X is basically heated to, for example, 150 to 400 °C by the above-described heater 3. Then, a conductive DLC film is formed on the back surface of the base material X by applying a negative DC voltage or a negative pulse voltage from the bias power source (not shown) to the base material X and additionally heating the base material X with the heater 3 or ion energy in the plasma.

The hydrophilic treatment chamber S6 is a treatment chamber in which the base material X held in the tray Y is loaded along with the tray Y delivered from the second film formation chamber S5, and the base material X is subjected to a hydrophilic treatment to be given hydrophilicity. Specifically, in the hydrophilic treatment chamber S6, at least a pair of antennas 2 is provided at positions at which the base material X is sandwiched therebetween, and in this embodiment, one set of the pair of inductively coupled antennas 2 is provided. Then, inductively coupled discharge plasma containing oxygen ions is generated in the vicinity of the front surface and the back surface of the base material X by applying high-frequency power from the high-frequency power source (not shown) to the antennas 2 via the matching device (not shown) and supplying oxygen gas into the chamber. The front surface and the back surface of the base material X are subjected to the hydrophilicity treatment by this oxygen plasma.

The tray storage chamber S7 is a chamber in which the base material X held in the tray Y is loaded along with the tray Y delivered from the hydrophilic treatment chamber S6 and stored. Air in the tray storage chamber S7 is exhausted by a suction mechanism P such as a pump, and the tray storage chamber S7 is maintained at a predetermined degree of vacuum.

The tray delivery chamber S1, the plasma cleaning chamber S2, the ion implantation chamber S3, the first film formation chamber S4, the second film formation chamber S5, the hydrophilic treatment chamber S6, and the tray storage chamber S7 communicate with each other. A differential exhaust chamber S8 in which air is exhausted by a suction mechanism P1 such as a common pump is interposed between the plasma cleaning chamber S2 and the ion implantation chamber S3, between the ion implantation chamber S3 and the first film formation chamber S4, and between the second film formation chamber S5 and the hydrophilic treatment chamber S6. Then, each of these chambers is communicated by a slit (not shown) through which the tray Y can pass, and thus air in the plasma cleaning chamber S2, the ion implantation chamber S3, the first film formation chamber S4, the second film formation chamber S5, and the hydrophilic treatment chamber S6 is differentially exhausted. Accordingly, each of the plasma treatment chambers S2 to S6 can be maintained at a predetermined degree of vacuum without providing a gate valve or the like between the chambers.

The lift mechanism 10 continuously conveys the tray Y to a plurality of plasma treatment chambers S2 to S6. Here, the lift mechanism 10 conveys the tray Y to the plasma cleaning chamber S2, the ion implantation chamber S3, the first film formation chamber S4, the second film formation chamber S5, and the hydrophilic treatment chamber S6 in that order, and more specifically, conveys the tray from the tray delivery chamber S1 to the tray storage chamber S7.

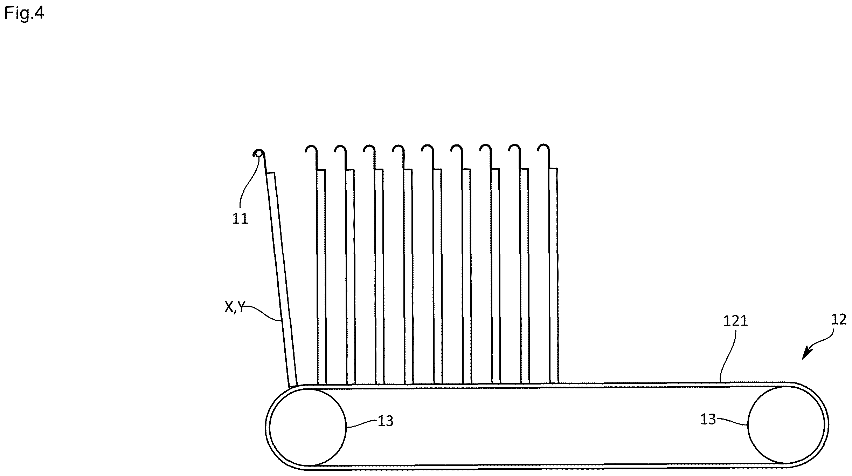

Specifically, as shown in FIG. 4, the lift mechanism 10 includes a rope 11 spanning the plurality of plasma treatment chambers S1 to S6 and a drive source (not shown) such as a motor for moving the rope 11 between the plurality of plasma treatment chambers S2 to S6.

Here, as shown in FIGS. 2 and 4, the tray Y of the present embodiment includes a hooking part Ya which is hooked on the rope 11, for example, at an upper end portion thereof, and is configured to be suspended from the rope 11.

The rope 11 allows the hooking part Ya of the tray Y to be hooked thereon, is made of, for example, a metal, a glass fiber, a carbon fiber, or the like, and is a stainless steel rope here.

In this embodiment, the rope 11 is provided to be spanned across each of the chambers from the tray delivery chamber S1 to the tray storage chamber S7, to move above each of the chambers from the tray delivery chamber S1 to the tray storage chamber S7, then to move below each of the chambers from the tray storage chamber S7 to the tray delivery chamber S1, and to be circulated through each of these chambers.

Further, as shown in FIG. 4, in the plasma treatment apparatus 100 of the present embodiment, the plurality of trays Y is arranged and provided, and the plasma treatment apparatus 100 includes a conveyance mechanism 12 for sequentially conveying these trays Y to the rope 11.

In this conveyance mechanism 12, the plurality of trays Y is placed, and the trays Y are sequentially conveyed toward the rope 11. Specifically, the conveyance mechanism 12 includes, for example, a pair of rollers 13 and an endless belt 121 wound around the rollers 13.

A relative positional relationship between the conveyance mechanism 12 and the above-described rope 11 is set so that, the hooking part Ya of the tray Y is hooked on the rope 11 and the tray Y is suspended from the rope 11 as the tray Y falls from an edge of the endless belt 121.

More specifically, the tray Y placed on the endless belt 121 and moving toward the rope 11 gradually starts to descend along a surface of the roller 13 when passing the apex of the front roller 13 around which the endless belt 121 is wound, and is in a tilted posture of tilting forward. Then, the rope 11 and the endless belt 121 are disposed so that the hooking part Ya of the tray Y is hooked on the rope 11 before the tray Y falls.

Further, the plasma treatment apparatus 100 of the present embodiment further includes an unloading mechanism (not shown) which sequentially receives the tray Y from the rope after the film forming treatment.

The unloading mechanism has the same configuration as that of the conveyance mechanism 12 shown in FIG. 4, and receives the tray Y by a reverse operation of the above-described conveyance mechanism 12.

That is, the unloading mechanism includes, for example, a pair of rollers and an endless belt wound around the rollers. Then, the tray Y sent by the rope 11 is lifted by being placed on the endless belt, thus the hooking part Ya of the tray Y is separated from the rope 11, and the tray Y is collected.

With such a configuration, the plurality of trays Y placed on a delivery path 12 is delivered toward the rope 11, automatically sequentially transfer to the rope 11, and then are automatically sequentially conveyed to the above-described various plasma treatment chambers S2 to S6 by the movement of the rope 11 due to the drive source (not shown) such as a motor.

Then, a negative DC voltage or a negative pulse voltage (a bias voltage) from the above-described bias power source (not shown) is applied to the rope 11, and this bias voltage is applied to the base material X via the rope 11 and the tray Y suspended from the rope 11.

According to the plasma treatment apparatus 100 of the present embodiment having such a configuration, since the tray Y holding the base material X can be continuously conveyed to the plurality of plasma treatment chambers S2 to S6 by the lift mechanism 10, even when the base material X is difficult to wind up, a continuous film formation treatment can be performed. Of course, it goes without saying that the plasma treatment apparatus 100 can be applied to the base material X which is not difficult to wind up.

Further, since the plurality of plasma treatment chambers S2 to S6 communicates with each other and the air in the respective chambers is differentially exhausted, the tray Y can be continuously conveyed and the respective plasma treatment chambers S2 to S6 can be maintained at a desired degree of vacuum by communicating the plurality of plasma treatment chambers S2 to S6 with each other.

Further, since the lift mechanism 10 is configured using the rope 11 spanning the plurality of plasma treatment chambers S2 to S6 and the tray Y can be hooked on the rope 11, the lift mechanism 10 can have a simple structure.

Moreover, since the delivery path 12 sequentially delivers the plurality of trays Y to the rope 11, the delivery of the plurality of trays Y can be automated, the film can be continuously formed on a large number of base materials X held in the plurality of trays Y at once, and thus further high efficiency can be achieved.

Moreover, since the conveyance mechanism 12 includes the endless belt 121 which delivers the tray Y to the rope 11, and is configured so that, the hooking part Ya provided on the tray Y is hooked on the rope 11 and the tray Y is suspended from the rope 11 as the tray Y falls from an edge of the endless belt 121. As a result, automatic delivery of the trays Y can be realized with a simple configuration.

In addition, since the tray Y holding the base material X in the standing posture is conveyed to the plasma cleaning chamber S2, the ion implantation chamber S3, the first film formation chamber S4, the second film formation chamber S5, and the hydrophilic treatment chamber S6, and the pair of antennas 2 is provided in the plasma cleaning chamber S2, the ion implantation chamber S3, and the hydrophilic treatment chamber S6 to sandwich the base material X, both surfaces of the base material X can be plasma-treated in each of the chambers, and the DLC film can be formed more efficiently than in the related art.

The present disclosure is not limited to the above-described embodiment.

For example, in the above-described embodiment, the rope 11 has been described as a stainless steel rope, but when the rope 11 is made of a conductive material such as a metal or a carbon fiber, since a bias voltage is applied to the base material X via the rope 11, bias voltages having the same magnitude are simultaneously applied to the plurality of base materials X held in separate trays Y.

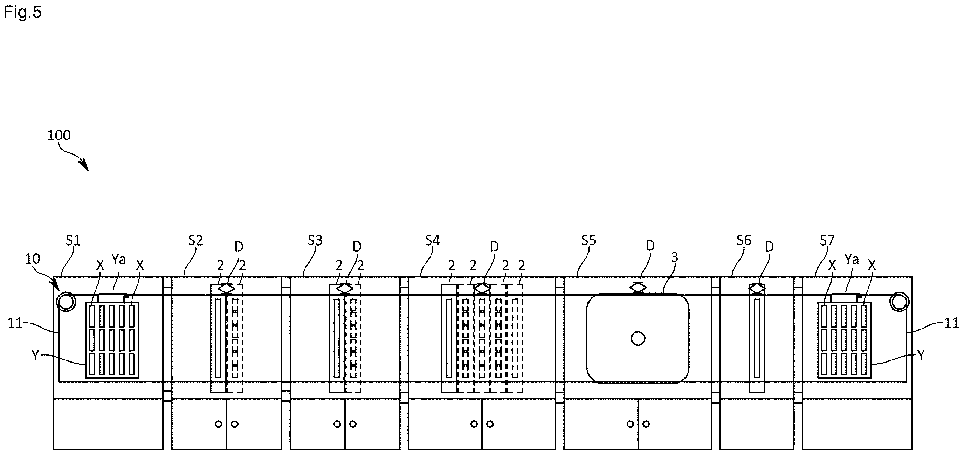

On the other hand, the rope 11 may be made of a non-conductive material such as a glass rope. In this case, as shown in FIG. 5, for example, a conductive member D such as a pantograph may be provided in each of the plasma treatment chambers S2 to S6, and a bias voltage may be applied to the base material X via the conductive member D. As shown in FIG. 5, the hooking part Ya may have an elongated shape in the conveying direction so that the bias voltage can be applied to the base material X at an appropriate timing.

With such a configuration, bias voltages having different magnitudes can be applied to the base material X in the respective plasma treatment chambers S2 to S6. A bias voltage having a magnitude suitable for the process in each of the plasma treatment chambers S2 to S6 can be applied to the base material X, a degree of freedom in the film formation process can be improved, and as a result, a higher quality film can be formed.

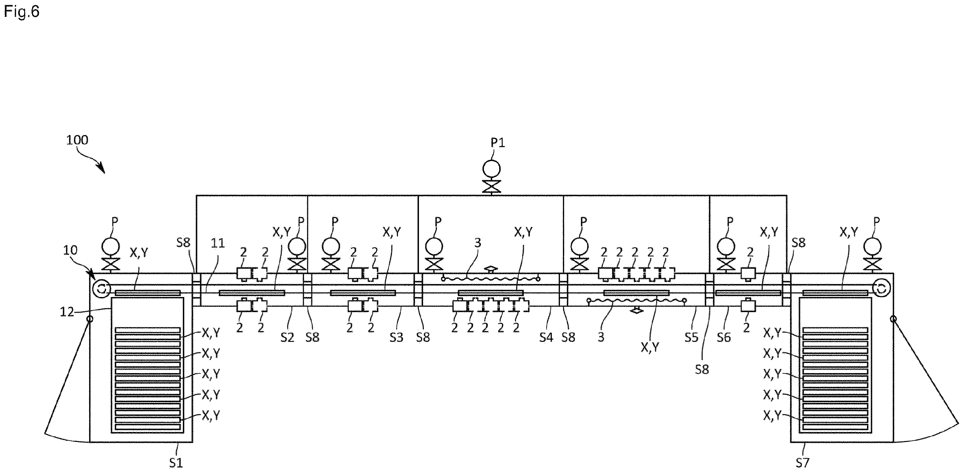

Further, in the above-described embodiment, although the rope 11 is provided to pass above and below the plasma treatment chambers S2 to S6, the arrangement of the rope 11 is not limited thereto, and as shown in FIG. 6, for example, the rope 11 may be disposed to come and go between the plasma treatment chambers S2 to S6 above the plasma treatment chambers S2 to S6.

Further, the base material X is not limited to aluminum, and may have at least one kind of a metal among alloys such as nickel (Ni), iron (Fe), magnesium (Mg), titanium (Ti), and stainless steel containing these metals.

Moreover, the formation of the gas barrier film is not limited to that described in the above embodiment, and for example, a plasma CVD method, a vacuum vapor deposition method, a sputtering method, an ion plating method, or the like may be used.

In addition, it should be appreciated that the present invention is not limited to any of the above-described embodiments but can be variously modified without departing from the scope of the invention, which is defined by the claims.

### [Reference Signs List]

100 Plasma treatment apparatus
X Base material
Y Tray
Ya Hooking part
S1 Tray delivery chamber
S2 Plasma cleaning chamber
S3 Ion implantation chamber
S4 First film formation chamber
S5 Second film formation chamber
S6 Hydrophilic treatment chamber
S7 Tray storage chamber
S8 Differential exhaust chamber
10 Lift mechanism
P Suction mechanism
2 Antenna
3 Heater
11 Rope
12 Conveyance mechanism
121 Endless belt
13 Roller

## Claims

1. A plasma treatment apparatus (100), comprising:
a plurality of plasma treatment chambers (S2, S3, S4, S5, S6) in which a plasma treatment is performed on a base material (X);
a tray (Y) configured to hold the base material (X) in a standing posture; and
a lift mechanism (10) configured to continuously convey the tray (Y) to the plurality of plasma treatment chambers (S2, S3, S4, S5, S6), wherein
the lift mechanism (10) comprises a rope (11) which spans the plurality of plasma treatment chambers (S2, S3, S4, S5, S6) and on which the tray (Y) is hooked, and a drive source which moves the rope between the plurality of plasma treatment chambers.

2. The plasma treatment apparatus (100) according to claim 1, wherein the plurality of plasma treatment chambers (S2, S3, S4, S5, S6) communicates with each other, and a differential exhaust chamber (S8) is provided between the chambers.

3. The plasma treatment apparatus (100) according to claim 1, wherein a plurality of the trays (Y) is installed, and a conveyance mechanism (12) which sequentially conveys the trays (Y) to the rope (11) is further comprised.

4. The plasma treatment apparatus (100) according to claim 3, wherein:
the conveyance mechanism (12) has an endless belt (121) that feeds the tray (Y) to the rope (11); and
a hooking part (Ya) provided on the tray (Y) is hooked on the rope (11) and the tray (Y) is suspended from the rope (11) as the tray (Y) falls from an edge of the endless belt (121).

5. The plasma treatment apparatus (100) according to claim 1, wherein:
a plasma cleaning chamber (S2) in which the base material (X) is plasma-cleaned, an ion implantation chamber (S3) in which carbon ions are implanted into the base material (X), a first film formation chamber (S4) in which a DLC film is formed on one surface of the base material (X), a second film formation chamber (S5) in which a DLC film is formed on the other surface of the base material (X), and a hydrophilic treatment chamber (S6) in which the base material is hydrophilically treated with oxygen plasma are provided as the plasma treatment chamber; and
the lift mechanism (10) conveys the tray (Y) to the plasma cleaning chamber (S2), the ion implantation chamber (S3), the first film formation chamber (S4), the second film formation chamber (S5), and the hydrophilic treatment chamber (S6) in that order.

6. The plasma treatment apparatus (100) according to claim 5, wherein, in each of the plasma cleaning chamber (S2), the ion implantation chamber (S3), and the hydrophilic treatment chamber (S6), at least a pair of antennas (2) which generates plasma in the chamber is provided at positions at which the base material (X) is sandwiched therebetween.

## Patentansprüche

1. Plasmabehandlungsvorrichtung (100), aufweisend:
eine Vielzahl von Plasmabehandlungskammern (S2, S3, S4, S5, S6), in denen eine Plasmabehandlung an einem Grundmaterial (X) durchgeführt wird;
eine Schale (Y), die dafür konfiguriert ist, das Grundmaterial (X) in aufrechter Stellung zu halten; und
einen Hebemechanismus (10), der dafür konfiguriert ist, die Schale (Y) kontinuierlich zu der Vielzahl von Plasmabehandlungskammern (S2, S3, S4, S5, S6) zu befördern, wobei
der Hebemechanismus (10) ein Seil (11), das die Vielzahl von Plasmabehandlungskammern (S2, S3, S4, S5, S6) überspannt und an dem die Schale (Y) eingehakt wird, und eine Antriebsquelle aufweist, die das Seil zwischen der Vielzahl von Plasmabehandlungskammern bewegt.

2. Plasmabehandlungsvorrichtung (100) nach Anspruch 1, wobei die Vielzahl von Plasmabehandlungskammern (S2, S3, S4, S5, S6) miteinander in Verbindung steht und eine Differentialauslasskammer (S8) zwischen den Kammern vorgesehen ist.

3. Plasmabehandlungsvorrichtung (100) nach Anspruch 1, wobei eine Vielzahl der Schalen (Y) installiert ist und ferner ein Beförderungsmechanismus (12), der die Schalen (Y) sequentiell zum Seil (11) befördert, vorgesehen ist.

4. Plasmabehandlungsvorrichtung (100) nach Anspruch 3, wobei
der Beförderungsmechanismus (12) ein Endlosband (121) aufweist, das die Schale (Y) dem Seil (11) zuführt; und
ein an der Schale (Y) vorgesehener Einhakteil (Ya) am Seil (11) eingehakt wird und die Schale (Y) vom Seil (11) herabhängt, während die Schale (Y) von einem Rand des Endlosbandes (121) fällt.

5. Plasmabehandlungsvorrichtung (100) nach Anspruch 1, wobei:
eine Plasmareinigungskammer (S2), in der das Grundmaterial (X) plasmagereinigt wird, eine Ionenimplantationskammer (S3), in der Kohlenstoffionen in das Grundmaterial (X) implantiert werden, eine erste Filmausbildungskammer (S4), in der ein DLC-Film auf einer Oberfläche des Grundmaterials (X) ausgebildet wird, eine zweite Filmausbildungskammer (S5), in der ein DLC-Film auf der anderen Oberfläche des Grundmaterials (X) ausgebildet wird, und eine Kammer (S6) für eine hydrophile Behandlung, in der das Grundmaterial mit einem Sauerstoffplasma hydrophil behandelt wird, als die Plasmabehandlungskammer vorgesehen sind; und
der Hebemechanismus (10) die Schale (Y) zu der Plasmareinigungskammer (S2), der Ionenimplantationskammer (S3), der ersten Filmausbildungskammer (S4), der zweiten Filmausbildungskammer (S5) und der Kammer (S6) für eine hydrophile Behandlung in dieser Reihenfolge befördert.

6. Plasmabehandlungsvorrichtung (100) nach Anspruch 5, wobei in jeder der Plasmareinigungskammer (S2), der Ionenimplantationskammer (S3) und der Kammer (S6) für eine hydrophile Behandlung zumindest ein Paar Antennen (2), das in der Kammer ein Plasma erzeugt, an Positionen vorgesehen ist, an denen das Grundmaterial (X) dazwischen sandwichartig angeordnet ist.

## Revendications

1. Appareil de traitement au plasma (100), comprenant :
une pluralité de chambres de traitement au plasma (S2, S3, S4, S5, S6) dans lesquelles un traitement au plasma est réalisé sur un matériau de base (X) ;
un plateau (Y) configuré pour maintenir le matériau de base (X) dans une posture verticale ; et
un mécanisme de soulèvement (10) configuré pour convoyer simultanément le plateau (Y) vers la pluralité de chambres de traitement au plasma (S2, S3, S4, S5, S6), dans lequel
le mécanisme de soulèvement (10) comprend une corde (11) qui s'étend sur la pluralité de chambres de traitement au plasma (S2, S3, S4, S5, S6) et à laquelle le plateau (Y) est accroché, et une source d'entraînement qui déplace la corde entre la pluralité de chambres de traitement au plasma.

2. Appareil de traitement au plasma (100) selon la revendication 1, dans lequel la pluralité de chambres de traitement par plasma (S2, S3, S4, S5, S6) communiquent les unes avec les autres, et une chambre d'évacuation différentielle (S8) est disposée entre les chambres.

3. Appareil de traitement au plasma (100) selon la revendication 1, dans lequel une pluralité de plateaux (Y) est installée, et un mécanisme de convoyage (12) qui convoie séquentiellement les plateaux (Y) vers la corde (11) est en outre inclus.

4. Appareil de traitement au plasma (100) selon la revendication 3, dans lequel :
le mécanisme de convoyage (12) a une courroie sans fin (121) qui alimente la corde (11) en plateau (Y) ; et
une partie d'accrochage (Ya) disposée sur le plateau (Y) est accrochée à la corde (11) et le plateau (Y) est suspendu depuis la corde (11) lorsque le plateau (Y) tombe depuis un bord de la courroie sans fin (121).

5. Appareil de traitement au plasma (100) selon la revendication 1, dans lequel :
une chambre de nettoyage au plasma (S1) dans laquelle le matériau de base (X) est nettoyé au plasma, une chambre d'implantation d'ions (S3) dans laquelle des ions carbone sont implantés dans le matériau de base (X), une première chambre de formation de film (S4) dans laquelle un film de CDA est formé sur une surface du matériau de base (X), une deuxième chambre de formation de film (S5) dans laquelle un film de CDA est formé sur l'autre surface du matériau de base (X), et une chambre de traitement hydrophile (S6) dans laquelle le matériau de base est traité de manière hydrophile avec un plasma à l'oxygène sont présentes en tant que chambre de traitement au plasma ; et
le mécanisme de soulèvement (10) convoie le plateau (Y) vers la chambre de nettoyage au plasma (S2), la chambre d'implantation d'ions (S3), la première chambre de formation de film (S4), la deuxième chambre de formation de film (S5), et la chambre de traitement hydrophile (S6) dans cet ordre.

6. Appareil de traitement au plasma (100) selon la revendication 5, dans lequel, dans chacune parmi la chambre de nettoyage au plasma (S2), la chambre d'implantation d'ions (S3), et la chambre de traitement hydrophile (S6), au moins une paire d'antennes (2) générant un plasma dans la chambre sont disposées à des positions auxquelles le matériau de base (X) est pris en sandwich entre elles.
